# FASCICULE DE BREVET EUROPEEN

(11) **EP 3 545 551 B1**
(45) Date de publication et mention de la délivrance du brevet: **04.11.2020**
(21) Numéro de dépôt: 17811641.4
(22) Date de dépôt: 20.11.2017
(51) Int. Cl.: H01L 23/495, H01L 23/498, H01L 25/07

(54) **CIRCUIT INTEGRE FORME D'UN EMPILEMENT DE DEUX PUCES CONNECTEES EN SERIE**
INTEGRIERTE SCHALTUNG AUS EINEM STAPEL VON ZWEI IN REIHE GESCHALTETEN CHIPS
INTEGRATED CIRCUIT FORMED FROM A STACK OF TWO SERIES-CONNECTED CHIPS

(30) Priorité: 23.11.2016 FR 1661379
(43) Date de publication de la demande: 02.10.2019
(73) Titulaire: Exagan, 38040 Grenoble Cedex 9 (FR)
(72) Inventeur: LO VERDE, Domenico, 79189, Bad Krozingen, (DE); GUILLOT, Laurent, 31600 Seysses (FR); LETERTRE, Fabrice, 38100 Grenoble (FR)
(74) Mandataire: IP Trust
(86) Numéro de dépôt international: PCT/FR2017/053169
(87) Numéro de publication internationale: WO 2018/096245

(56) Documents cités:
- EP-A1- 2 511 952
- JP-A- 2013 222 905

## Description

### DOMAINE DE L'INVENTION

La présente invention concerne un circuit intégré comprenant un empilement d'une puce incluant un transistor en mode enrichissement sur une puce incluant un transistor à haute tension en mode déplétion, les deux puces étant connectées en série.

### ARRIERE PLAN TECHNOLOGIQUE DE L'INVENTION

Les transistors HEMT (transistors à haute mobilité électronique) élaborés sur des matériaux semi-conducteurs III-N sont classiquement « normally on », c'est-à-dire qu'ils présentent une tension de seuil négative et peuvent conduire le courant avec une tension de grille à 0V. Ces composants avec tensions de seuil négatives sont appelés composants en mode déplétion (« depletion mode » ou « D-mode » selon la terminologie anglo-saxonne).

Il est préférable pour les applications d'électronique de puissance d'avoir des composants dits « normally off », c'est-à-dire présentant une tension de seuil positive : ces composants ne peuvent pas conduire le courant lorsque la tension de grille est à 0 volt et sont communément appelés composants en mode enrichissement (« E-mode »).

La fabrication de composants à haute tension sur matériaux semi-conducteurs III-N en E-mode s'avère complexe. Une alternative à un composant E-mode haute tension simple est de combiner un composant D-mode à haute tension avec un composant E-mode, par exemple à basse tension. Un tel dispositif hybride comprend typiquement un transistor HEMT D-mode élaboré sur matériaux semi-conducteurs III-N et un transistor MOSFET (Transistor métal/oxyde/semi-conducteur à effet de champ) E-mode élaboré sur silicium.

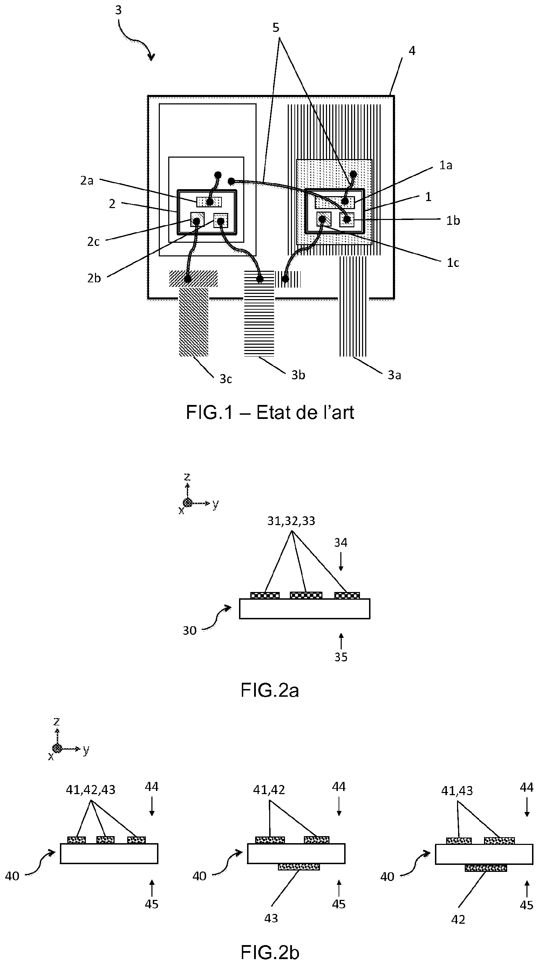

Par exemple, comme illustré sur la figure 1, des puces 1,2 comprenant respectivement les composants HEMT D-mode et MOSFET peuvent être couplées pour former un circuit intégré de type cascode 3 : le drain 2a et la source 2b de la puce MOSFET E-mode 2 sont respectivement connectés à la source 1b et à la grille 1c de la puce HEMT D-mode 1 ; cette connexion électrique se fait dans le boitier 4 du circuit intégré 3 comprenant les deux puces électroniques 1,2, habituellement par connexion filaire 5 (« wire bonding » selon la terminologie anglo-saxonne) entre différents plots de contact de grille 1c,2c, de source 1b,2b et de drain 1a,2a accessibles sur chacune des puces 1,2. Dans un circuit intégré cascode 3, la grille 2c de la puce MOSFET 2 contrôle la mise en mode passant ou bloquant du circuit intégré 3.

Le plot de contact de grille 2c de la puce MOSFET 2 est connecté dans le boitier 4 du circuit intégré 3 à une broche de grille 3c. Le plot de contact de source 2b de la puce MOSFET 2 est connecté dans le boitier 4 à une broche de source 3b. Enfin, le plot de contact de drain de la puce HEMT 1 est connecté, toujours dans le boitier 4, à une broche de drain 3a. Habituellement, les connexions entre les plots de contact des puces et les broches sont faits par connexion filaire 5 ou à l'aide de clips de raccordement électrique. Les trois broches 3a,3b,3c constituent les terminaux électriques du circuit intégré 3 vers l'extérieur du boitier 4.

Dans un circuit intégré de type cascode, alors qu'une commutation rapide est un des avantages attendus d'une puce HEMT, les interconnexions (notamment les connexions filaires) entre les différents composants limitent la vitesse de commutation. En effet, les interconnexions créent des surtensions ou sous-tensions parasites pouvant endommager les différents transistors lors de chaque commutation. Il est donc nécessaire de réduire les fronts de commutations (vitesse de commutation) pour limiter ces excursions en tension parasites. Pour accéder à des vitesses de commutation élevées, il est donc nécessaire de minimiser les inductances et résistances parasites liées aux interconnexions dans un arrangement cascode.

De plus, le fait que les deux puces soient côte-à-côte dans le boitier nécessite l'utilisation d'un substrat d'interconnexion (par exemple, DBC for « Direct bonded copper » selon la terminologie anglo-saxonne) et augmente les dimensions latérales nécessaires du boitier.

Le document US8847408 présente un circuit intégré cascode dépourvu de substrat d'interconnexion comprenant un premier transistor III-N sur lequel est empilé un second transistor MOSFET ; la face arrière du transistor MOSFET qui comporte le plot de contact de drain du MOSFET est assemblée sur le plot de contact de source du transistor III-N, sur la face avant de ce dernier. Bien que réduisant les dimensions latérales nécessaires du boitier cette configuration présente certains inconvénients. Notamment, la présence des inductances et résistances parasites liées aux connexions électriques entre les plots de contact de grille, de source du MOSFET et les broches associées.

Le document JP2013222905 présente un circuit intégré comprenant un transistor en GaN et un transistor MOS qui sont empilés.

Le document EP2511952 décrit une disposition empilée de dies actifs comportant un drain composite, une source composite et une grille composite.

### OBJET DE L'INVENTION

Un objet de la présente invention est de proposer une solution alternative, obviant tout ou partie des inconvénients de l'état de l'art. Un objet de l'invention est notamment de proposer un circuit intégré comprenant un empilement d'une puce comportant un dispositif en mode enrichissement sur une puce comportant un transistor à haute tension en mode déplétion, dans lequel les inductances et résistances parasites liées aux interconnexions sont réduites.

### BREVE DESCRIPTION DE L'INVENTION

La présente invention concerne un circuit intégré comprenant une première puce comportant un transistor à haute tension en mode déplétion et une deuxième puce comportant un dispositif en mode enrichissement ; la première puce comporte sur une face avant des premiers plots de contact de grille, de source et de drain et la deuxième puce comporte des deuxièmes plots de contact de grille, de source et de drain.

Le circuit intégré est remarquable en ce que :
- La première puce et la deuxième puce sont assemblées entre elles au niveau de leurs faces avant respectives et forment un empilement, la surface de la face avant de la première puce étant supérieure à celle de la deuxième puce de manière à ce qu'une partie périphérique de la face avant de la première puce ne soit pas masquée par la deuxième puce,
- La première puce comporte au moins un plot de contact additionnel disposé sur sa face avant, isolé électriquement du transistor à haute tension en mode déplétion, et en contact avec le deuxième plot de contact de grille,
- Le premier plot de contact de grille est en contact avec le deuxième plot de contact de source et/ou le premier plot de contact de source est en contact avec le deuxième plot de contact de drain,
- Le premier plot de contact de grille et le plot de contact additionnel s'étendent au moins en partie dans la partie périphérique de la première puce.

Selon d'autres caractéristiques avantageuses et non limitatives de l'invention, prises seules ou selon toute combinaison techniquement réalisable :
- le circuit intégré comprend un boitier comportant au moins trois terminaux électriques, un terminal de grille, un terminal de source et un terminal de drain, et dans lequel est disposé l'empilement, la face arrière de la première puce étant disposée sur une plaque structurelle du boitier connectée au terminal de source ;
- le premier plot de contact de grille, en contact avec le deuxième plot de contact de source, s'étend au-dessus d'une région active du transistor de la première puce et forme la surface principale d'assemblage entre la première puce et la deuxième puce ;
- le deuxième plot de contact de drain, en face arrière de la deuxième puce, est connecté au premier plot de contact de source situé dans la partie périphérique, au moyen d'un clip de raccordement électrique ;
- le premier plot de contact de source, en contact avec le deuxième plot de contact de drain, s'étend au-dessus d'une région active du transistor de la première puce et forme la surface principale d'assemblage entre la première puce et la deuxième puce ;
- le deuxième plot de contact de source, en face arrière de la deuxième puce, est connecté au premier plot de contact de grille au moyen d'un clip de raccordement électrique ;
- le premier plot de contact de source, en contact avec le deuxième plot de contact de drain, s'étend au-dessus d'une région active du transistor de la première puce et forme la surface principale d'assemblage entre la première puce et la deuxième puce ;
- le deuxième plot de contact de source, en face avant de la deuxième puce, est en contact avec le premier plot de contact de grille ;
- le plot de contact additionnel, le premier plot de contact de grille et le premier plot de contact de drain sont respectivement connectés au terminal de grille, au terminal de source et au terminal de drain ;
- au moins la connexion entre le premier plot de contact de grille et le terminal de source, et la connexion entre le premier plot de contact de drain et le terminal de drain sont réalisées au moyen de clips de raccordement électrique ;
- la connexion entre le premier plot de contact de grille et le terminal de source se fait au moyen d'un clip de raccordement électrique entre la plaque structurelle du boitier et le premier plot de contact de grille, le terminal de source étant électriquement relié à la plaque structurelle ;
- la connexion entre le plot de contact additionnel et le terminal de grille est réalisée au moyen d'une connexion filaire ou d'un clip de raccordement électrique ;
- le circuit intégré comprend un boitier comportant au moins quatre terminaux électriques, un terminal de grille, un terminal de source, un terminal de drain et un terminal supplémentaire de grille, et dans lequel est disposé l'empilement, la face arrière de la première puce étant disposée sur une plaque structurelle du boitier connectée au terminal de source ;
- la première puce comporte un plot de contact additionnel supplémentaire disposé sur sa face avant, isolé électriquement du transistor à haute tension en mode déplétion, et s'étendant au moins en partie dans la partie périphérique de la première puce ;
- le premier plot de contact de source, en contact avec le deuxième plot de contact de drain, s'étend au-dessus d'une région active du transistor de la première puce et forme la surface principale d'assemblage entre la première puce et la deuxième puce ;
- le deuxième plot de contact de source, en face avant de la deuxième puce, est en contact avec le plot de contact additionnel supplémentaire ;
- le plot de contact additionnel, le plot de contact additionnel supplémentaire, le premier plot de contact de drain et le premier plot de contact de grille sont respectivement connectés au terminal de grille, au terminal de source, au terminal de drain et au terminal supplémentaire de grille ;
- au moins la connexion entre le plot de contact additionnel supplémentaire et le terminal de source, et la connexion entre le premier plot de contact de drain et le terminal de drain sont réalisées au moyen de clips de raccordement électrique ;
- la connexion entre le plot de contact additionnel supplémentaire et le terminal de source se fait au moyen d'un clip de raccordement électrique entre la plaque structurelle du boitier et le plot de contact additionnel supplémentaire, le terminal de source étant électriquement relié à la plaque structurelle ;
- la connexion entre le plot de contact additionnel et le terminal de grille, et la connexion entre le premier plot de contact de grille et le terminal supplémentaire de grille sont réalisées au moyen de connexions filaires ou de clips de raccordement électrique ;
- la première puce et la deuxième puce sont assemblées entre elles, au niveau de leurs faces avant respectives, par soudage des plots de contact en vis-à-vis ;
- la face arrière de la première puce comporte un pavé conducteur assemblé par soudage sur la plaque structurelle du boitier ;
- le dispositif en mode enrichissement inclus dans la deuxième puce comprend un transistor en mode enrichissement dont une électrode de grille est connectée au plot de contact de grille de la deuxième puce ;
- le dispositif en mode enrichissement inclus dans la deuxième puce comprend un transistor en mode enrichissement et un composant de commande, une électrode de grille du transistor en mode enrichissement étant connectée à une entrée du composant de commande et une sortie du composant de commande étant connectée au plot de contact de grille de la deuxième puce.

### BREVE DESCRIPTION DES DESSINS

D'autres caractéristiques et avantages de l'invention ressortiront de la description détaillée qui va suivre en référence aux figures annexées sur lesquelles :
- la figure 1 présente un circuit intégré dans un boitier selon l'état de la technique ;
- les figures 2a à 2d présentent des éléments du circuit intégré conforme à l'invention ;
- les figures 3a et 3b présentent respectivement une vue en coupe et une vue plane d'un circuit intégré selon un premier mode de réalisation de l'invention ;
- les figures 4a et 4b présentent respectivement une vue en coupe et une vue plane d'un circuit intégré selon un deuxième mode de réalisation de l'invention ;
- les figures 5a et 5b présentent respectivement une vue en coupe et une vue plane d'un circuit intégré selon un troisième mode de réalisation de l'invention ;
- les figures 6a et 6b présentent respectivement une vue en coupe et une vue plane d'un circuit intégré selon un quatrième mode de réalisation de l'invention.

### DESCRIPTION DETAILLEE DE L'INVENTION

Dans la partie descriptive, les mêmes références sur les figures pourront être utilisées pour des éléments de même nature.

Les figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y. Par ailleurs, pour permettre une visualisation plus aisée des connexions dans le circuit intégré selon l'invention, les vues en coupe pourront dans certains cas représenter des éléments compris dans plusieurs plans verticaux (plans (y,z) sur les figures) différents.

Bien sur, les représentations schématiques des figures ne limitent en rien les configurations et positionnements des éléments du circuit intégré selon l'invention.

L'invention concerne un circuit intégré 100 comprenant une première puce 30 comportant un transistor à haute tension en mode déplétion (D-mode) et une deuxième puce 40 comportant un dispositif en mode enrichissement (E-mode). A titre d'exemple, le transistor à haute tension en mode déplétion pourra consister en un transistor HEMT élaboré sur GaN. Le dispositif en mode enrichissement pourra quant à lui consister en un transistor MOS à effet de champ (MOSFET) élaboré sur Silicium ; il pourra également consister en un dispositif comprenant un MOSFET couplé avec un composant de commande (driver).

La première puce 30 comporte, sur une face avant 34, des premiers plots de contact de grille 31, de source 32 et de drain 33 (figure 2a). La deuxième puce 40 comporte des deuxièmes plots de contact de grille 41, de source 42 et de drain 43 (figure 2b). Selon les modes de réalisation de l'invention, les deuxièmes plots de contact 41,42,43 pourront tous les trois être situés sur la face avant 44 de la deuxième puce 40, ou l'un parmi le deuxième plot de contact de drain 43 ou de source 42 pourra être situé sur la face arrière 45 de la deuxième puce 40.

Comme bien connu de l'homme du métier, les plots de contact sont composés d'un matériau métallique conducteur électrique, par exemple le cuivre, l'aluminium, le nickel ou tout autre matériau approprié. En particulier, le matériau métallique formant les plots de contacts est apte à être assemblé ou soudé. Les plots de contacts d'une puce selon l'invention pourront se présenter sous différentes formes : soit sous la forme de pavés en relief par rapport à la surface de la face avant de la puce, soit sous la forme de billes (« bumps » selon la terminologie anglo-saxonne) également en relief par rapport à la surface de la face avant de la puce. La disposition et les dimensions latérales (dans le plan (x,y)) des premiers 31,32,33 et deuxièmes 41,42,43 plots de contact sur les faces avant 34,44 respectives des première 30 et deuxième 40 puces ou la face arrière 45 de la deuxième puce 40 pourront être différentes, selon les modes de réalisation et variantes conformes à l'invention.

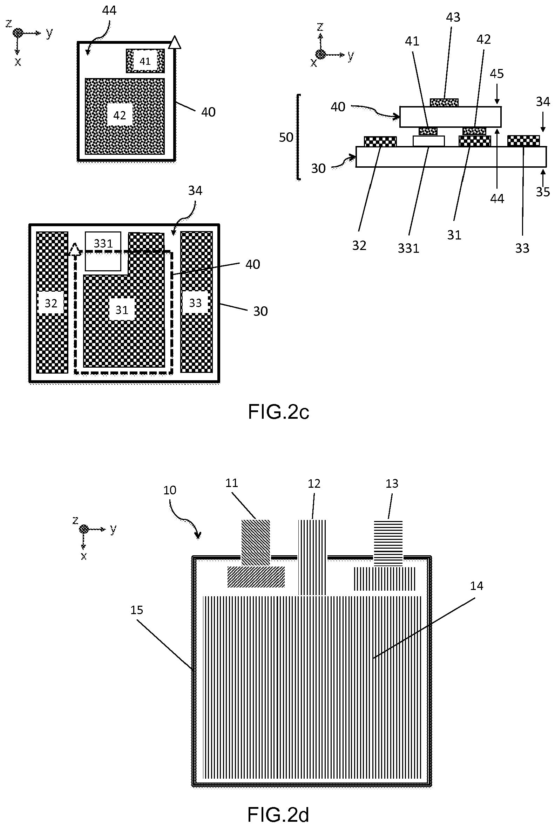

Dans le circuit intégré 100 selon l'invention, la première puce 30 et la deuxième puce 40 sont assemblées entre elles au niveau de leurs faces avant 34,44 respectives et forment un empilement 50 (figure 2c). La surface de la face avant 34 de la première puce 30 est supérieure à celle de la deuxième puce 40 de manière à ce qu'une partie périphérique de la face avant 34 de la première puce 30 ne soit pas masquée par la deuxième puce 40 : cette partie périphérique est par exemple illustrée sur la vue plane selon (x,y) de la figure 2c, c'est la partie à l'extérieur du contour en pointillé correspondant à la deuxième puce 40. Notons que la vue plane sur la figure 2c présente une vue de la deuxième puce 40 non assemblée, sa face avant 44 vers le haut, pour une meilleure visualisation de la disposition des deuxièmes plots de contact sur sa face avant 44. Dans l'empilement 50, elle est retournée, sa face avant 44 étant en vis-à-vis de la face avant 34 de la première puce. Sur la vue plane représentant la première puce 30, la deuxième puce 40 retournée est illustrée par le contour en pointillé ; le repère triangulaire sur le contour de la deuxième puce 40 permet de comprendre le positionnement des deuxièmes plots de contact situés sur la face avant 44, dans l'empilement 50.

En plus des premiers plots de contact 31,32,33 énoncés précédemment, la première puce 30 comporte au moins un plot de contact additionnel 331 disposé sur sa face avant 34. Le plot de contact additionnel 331 est isolé électriquement du transistor à haute tension en mode déplétion de la première puce 30. Comme les autres plots de contact, il est composé d'un matériau métallique conducteur électrique apte à être assemblé ou soudé à un autre plot de contact en vis-à-vis.

En particulier, selon l'invention, le plot de contact additionnel 331 est en contact avec le deuxième plot de contact de grille 41. L'assemblage pour la mise en contact du plot additionnel 331 et du deuxième plot de contact de grille 41 pourra être réalisé par un procédé de collage métallique par exemple par thermo-compression ou un procédé de soudage ou brasage entre les matériaux composant les plots de contact en vis-à-vis. Il est ainsi possible d'obtenir un contact électrique de bonne qualité entre le plot additionnel 331 et le deuxième plot de contact de grille 41, avec un chemin de conduction fortement réduit, notamment par rapport à des connexions filaires.

Selon l'invention, le plot de contact additionnel 331 s'étend au moins en partie dans la partie périphérique de la première puce 30. Il s'étend bien-sur également dans la partie qui sera masquée par la deuxième puce 40, de sorte à être en vis-à-vis avec le deuxième plot de contact de grille 41 de la deuxième puce 40 dans l'empilement 50.

Selon l'invention, le premier plot de contact de grille 31 s'étend lui aussi, au moins en partie dans la partie périphérique de la première puce 30.

Selon les modes de réalisation et variantes détaillées par la suite, l'assemblage des faces avant 34,44 des première 30 et deuxième 40 puces pourra conduire soit à la mise en contact du premier plot de contact de grille 31 avec le deuxième plot de contact de source 42, soit à la mise en contact du premier plot de contact de source 32 avec le deuxième plot de contact de drain 43, soit aux deux mises en contact précitées.

Avantageusement, le circuit intégré 100 comprend un boitier 10 dont une partie isolante 15 destinée à encapsuler les composants électroniques du circuit intégré 100 est formée par un matériau isolant électrique, typiquement de la résine. Le boitier 10 comporte au moins trois terminaux électriques, un terminal de grille 11, un terminal de source 12 et un terminal de drain 13, comme illustré sur la figure 2d. Par terminal électrique, on entend notamment une broche (telle qu'illustrée sur la figure 2d) ou un plot métallique ou tout autre moyen permettant de former un contact électrique externe du circuit intégré 100 : ce contact externe pourra ensuite être connecté à d'autres éléments, par exemple sur un circuit imprimé.

Le boitier 10 comporte également une plaque structurelle 14 conductrice. La plaque structurelle 14 est destinée à supporter les composants électroniques du circuit intégré 100. La plaque structurelle 14 est connectée à l'un des trois terminaux 11,12,13 ; dans le cas illustré sur la figure 2d, la plaque structurelle 14 est connectée au terminal de source 12. Dans la présente description, par « connecté », on entend électriquement connecté : soit directement, c'est-à-dire par contact direct entre les deux éléments connectés, soit indirectement, c'est-à-dire au moyen d'un élément intermédiaire, lui-même en contact avec les éléments électriquement connectés ; ledit élément intermédiaire pourra par exemple être un clip de raccordement électrique ou encore une ou une pluralité de connexions filaires. La plaque structurelle 14 est habituellement encapsulée, de même que les composants électroniques du circuit intégré 100, dans la partie isolante 15 du boitier 10.

L'empilement 50 est disposé sur la plaque structurelle 14 ; en particulier, la face arrière 35 de la première puce 30 est disposée sur la plaque structurelle 14 du boitier 10 connectée au terminal de source 12. A titre d'exemple, la face arrière 35 de la première puce 30 pourra comporter un pavé conducteur en contact direct ou assemblé au moyen d'un matériau conducteur électrique sur la plaque structurelle 14. Selon un autre exemple, la face arrière 35 de la première puce 30 pourra être assemblée au moyen d'un matériau adhésif conducteur électrique sur la plaque structurelle 14.

Les connexions électriques entre les deux puces 30,40 du circuit intégré 100 selon l'invention présentent des longueurs significativement réduites du fait du contact direct réalisé dans l'empilement 50. Par ailleurs, la présence du plot de contact additionnel 331 sur la face avant 34 de la première puce 30, permet également de connecter efficacement le plot de contact de grille 41 de la deuxième puce 40 et de le rendre accessible en face avant 34 de la première puce 30, en vue de sa connexion sur le terminal de grille 11 du boitier 10. Cela résulte en une significative réduction des résistances et inductances parasites au niveau des nœuds concernés de connexion.

L'empilement 50 du circuit intégré 100 selon l'invention présente également l'avantage d'occuper un espace réduit avec des dimensions latérales limitées aux dimensions de la première puce 30. Enfin, la configuration de l'empilement 50 permet de ne pas utiliser un substrat d'interconnexion, habituellement utilisé pour supporter et connecter les deux puces entre elles.

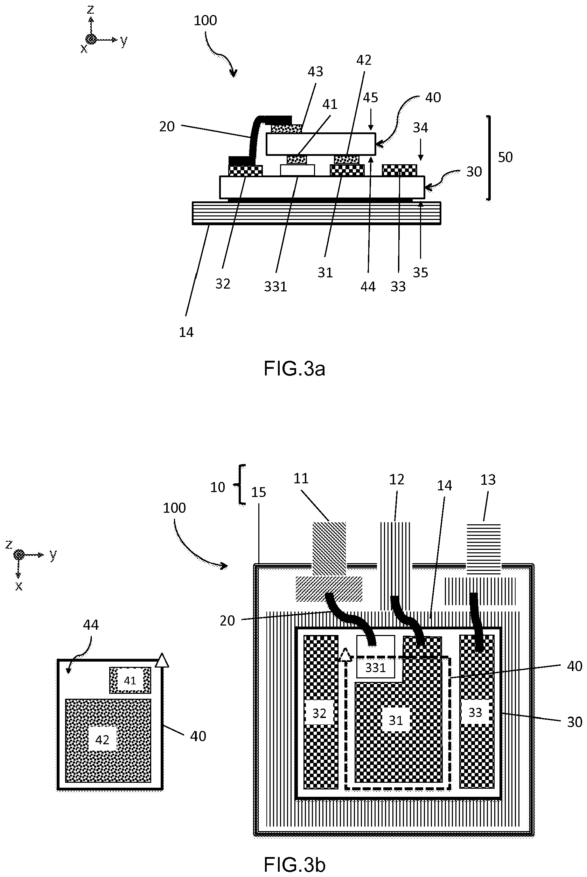

Selon un premier mode de réalisation de l'invention, le boitier 10 comporte trois terminaux électriques 11,12,13. L'empilement 50 du circuit intégré 100 se présente comme illustré sur les figures 3a et 3b.

Le premier plot de contact de grille 31, en contact avec le deuxième plot de contact de source 42, s'étend au-dessus d'une région active du transistor de la première puce 30, ce qui permet de mettre à profit une surface nécessairement présente du transistor (région active) et ainsi de limiter l'étendue des plots de contact sur des régions non actives du transistor. Notons que la région active du transistor à haute tension en mode déplétion correspond à la région entre l'électrode de source et l'électrode de drain du transistor, contenant le canal de conduction du courant.

Le premier plot de contact de grille 31 forme la surface principale d'assemblage entre la première puce 30 et la deuxième puce 40. Par surface principale d'assemblage, on entend la surface la plus étendue sur la face avant 34 de la première puce 30, qui servira, en plus d'établir un contact électrique entre les plots de contact en vis-à-vis, à assurer la tenue mécanique entre les deux puces 30,40. Le deuxième plot de contact de source 42 présente lui aussi une surface étendue sur la face avant 44 de la deuxième puce 40, surface qui viendra en contact avec le premier plot de contact de grille 31.

Avantageusement, le deuxième plot de contact de drain 43, en face arrière 45 de la deuxième puce 40, est connecté au premier plot de contact de source 32 situé dans la partie périphérique de la première puce 30, au moyen d'un clip de raccordement électrique 20 (figure 3a).

Enfin, le plot de contact additionnel 331, le premier plot de contact de grille 31 et le premier plot de contact de drain 33 sont respectivement connectés au terminal de grille 11, au terminal de source 12 et au terminal de drain 13, comme illustré sur la figure 3b. Préférentiellement, au moins la connexion entre le premier plot de contact de grille 31 et le terminal de source 12, et la connexion entre le premier plot de contact de drain 33 et le terminal de drain 13 sont réalisées au moyen de clips de raccordement électrique 20. Selon une variante (non représentée), la connexion entre le premier plot de contact de grille 31 et le terminal de source 12 se fait au moyen d'un clip de raccordement électrique 20 entre la plaque structurelle 14 du boitier 10 et le premier plot de contact de grille 31, le terminal de source 12 étant électriquement relié à la plaque structurelle 14.

La connexion entre le plot de contact additionnel 331 et le terminal de grille 11 peut être réalisée au moyen d'une connexion filaire ou d'un clip de raccordement électrique 20.

Selon ce premier mode de réalisation de l'invention, on obtient un circuit intégré 100, dont les première 30 et deuxième 40 puces sont connectées en arrangement cascode et dans lequel les résistances et inductances parasites liées aux connexions électriques entre les différents composants et éléments du circuit intégré 100 sont réduites du fait des chemins de connexion fortement réduits et de l'utilisation préférentielle de clips de raccordement électrique au lieu de connexions filaires sur les chemins de courant du circuit 100.

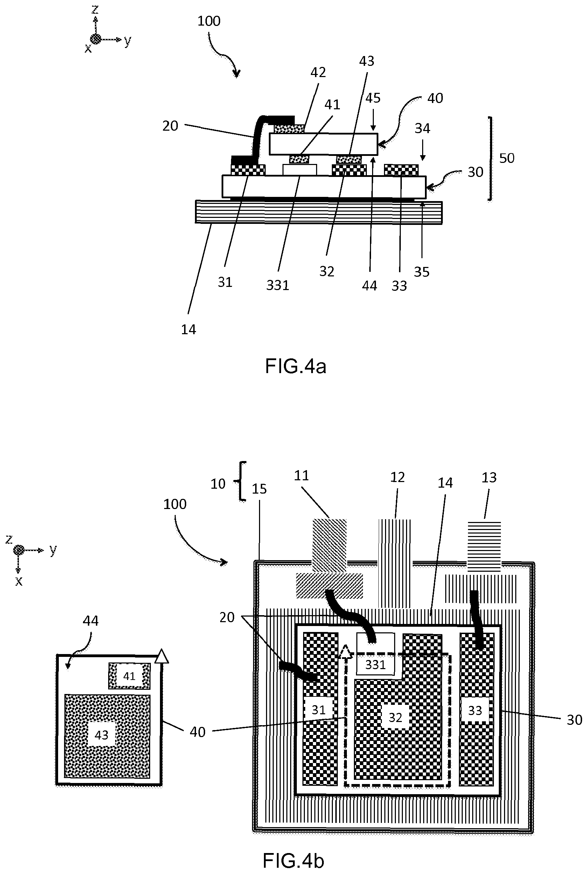

Selon un deuxième mode de réalisation de l'invention, le boitier 10 comporte également trois terminaux électriques 11,12,13 et l'empilement 50 du circuit intégré 100 se présente comme illustré sur les figures 4a et 4b.

Le premier plot de contact de source 32 est en contact avec le deuxième plot de contact de drain 43, il s'étend au-dessus de la région active du transistor de la première puce 30 et forme la surface principale d'assemblage entre la première puce 30 et la deuxième puce 40. Le deuxième plot de contact de drain 43 présente lui aussi une surface étendue sur la face avant 44 de la deuxième puce 40, surface qui viendra en contact avec le premier plot de contact de source 32.

Avantageusement, le deuxième plot de contact de source 42, en face arrière 45 de la deuxième puce 40, est connecté au premier plot de contact de grille 31 au moyen d'un clip de raccordement électrique 20.

Enfin, le plot de contact additionnel 331, le premier plot de contact de grille 31 et le premier plot de contact de drain 33 sont respectivement connectés au terminal de grille 11, au terminal de source 12 et au terminal de drain 13, comme illustré sur la figure 4b. Préférentiellement, au moins la connexion entre le premier plot de contact de grille 31 et le terminal de source 12, et la connexion entre le premier plot de contact de drain 33 et le terminal de drain 13 sont réalisées au moyen de clips de raccordement électrique 20. Comme illustré sur la figure 4b, la connexion entre le premier plot de contact de grille 31 et le terminal de source 12 peut être réalisée au moyen d'un clip de raccordement électrique 20 entre la plaque structurelle 14 du boitier 10 et le premier plot de contact de grille 31, le terminal de source 12 étant électriquement relié à la plaque structurelle 14.

La connexion entre le plot de contact additionnel 331 et le terminal de grille 11 peut être réalisée au moyen d'une connexion filaire ou d'un clip de raccordement électrique 20.

Selon ce deuxième mode de réalisation de l'invention, on obtient un circuit intégré 100, dont les première 30 et deuxième 40 puces sont connectées en arrangement cascode et dans lequel les résistances et inductances parasites liées aux connexions électriques entre les différents composants et éléments du circuit intégré 100 sont fortement réduites par rapport aux solutions de l'état de l'art.

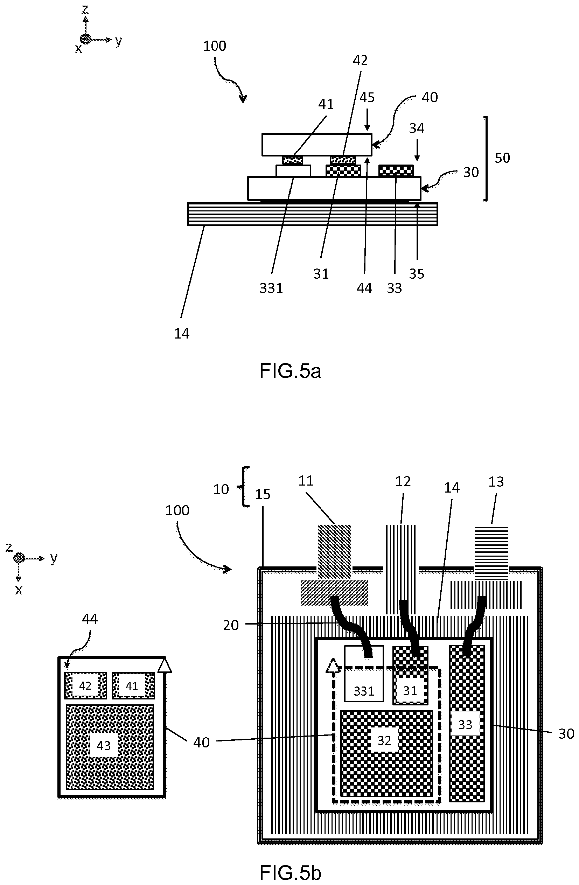

Selon un troisième mode de réalisation de l'invention, le boitier 10 comporte également trois terminaux électriques 11,12,13 et l'empilement 50 du circuit intégré 100 se présente comme illustré sur les figures 5a et 5b. Les deuxièmes plots de contact de grille 41, de source 42 et de drain 43 se situent sur la face avant 44 de la deuxième puce 40 (figure 5b) .

Le premier plot de contact de source 32 est en contact avec le deuxième plot de contact de drain 43 ; il s'étend au-dessus d'une région active du transistor de la première puce 30 et forme la surface principale d'assemblage entre la première puce 30 et la deuxième puce 40. Le deuxième plot de contact de drain 43 présente lui aussi une surface étendue sur la face avant 44 de la deuxième puce 40, surface qui viendra en contact avec le premier plot de contact de source 32.

Avantageusement, le deuxième plot de contact de source 42, en face avant 44 de la deuxième puce 40, est en contact avec le premier plot de contact de grille 31 (figures 5a).

Enfin, le plot de contact additionnel 331, le premier plot de contact de grille 31 et le premier plot de contact de drain 33 sont respectivement connectés au terminal de grille 11, au terminal de source 12 et au terminal de drain 13, comme illustré sur la figure 5b. Préférentiellement, au moins la connexion entre le premier plot de contact de grille 31 et le terminal de source 12, et la connexion entre le premier plot de contact de drain 33 et le terminal de drain 13 sont réalisées au moyen de clips de raccordement électrique 20. Comme mentionné dans les modes de réalisation précédents, la connexion entre le premier plot de contact de grille 31 et le terminal de source 12 peut être réalisée au moyen d'un clip de raccordement électrique 20 entre la plaque structurelle 14 du boitier 10 et le premier plot de contact de grille 31, le terminal de source 12 étant électriquement relié à la plaque structurelle 14.

La connexion entre le plot de contact additionnel 331 et le terminal de grille 11 peut être réalisée au moyen d'une connexion filaire ou d'un clip de raccordement électrique 20.

Selon ce troisième mode de réalisation de l'invention, on obtient un circuit intégré 100, dont les première 30 et deuxième 40 puces sont connectées en arrangement cascode et dans lequel les résistances et inductances parasites liées aux connexions électriques entre les différents composants et éléments du circuit intégré 100 sont fortement réduites par rapport aux solutions de l'état de l'art. Une connexion entre la face arrière 45 de la deuxième puce 40 et la face avant 34 de la première puce est également éliminée, puisque tous les deuxièmes plots de contact de la deuxième puce 40 (en face avant 44) sont en contact direct avec des plots de contact en face avant 34 de la première puce 30, ce qui réduit significativement le chemin de conduction et donc les inductances et résistances parasites associées.

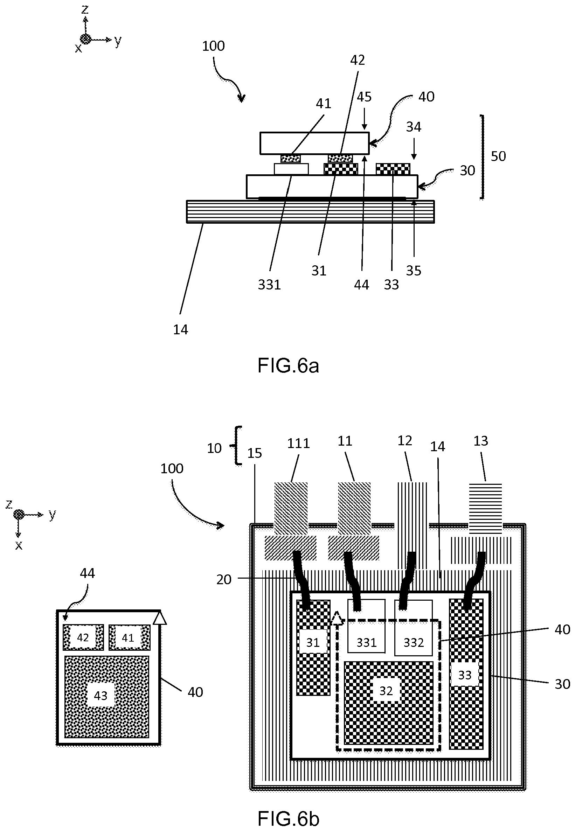

Selon un quatrième mode de réalisation de l'invention, le boitier 10 comporte au moins quatre terminaux électriques, un terminal de grille 11, un terminal de source 12, un terminal de drain 13 et un terminal supplémentaire de grille 111. L'empilement 50 du circuit intégré 100 se présente comme illustré sur les figures 6a et 6b. Les deuxièmes plots de contact de grille 41, de source 42 et de drain 43 se situent sur la face avant 44 de la deuxième puce 40 (figure 6b).

Avantageusement, la première puce 30 comporte un plot de contact additionnel supplémentaire 332 disposé sur sa face avant 34, isolé électriquement du transistor à haute tension en mode déplétion, et s'étendant au moins en partie dans la partie périphérique de la première puce 30. Le premier plot de contact de source 32 s'étend au-dessus de la région active du transistor de la première puce 30 et forme la surface principale d'assemblage entre la première puce 30 et la deuxième puce 40. Le deuxième plot de contact de drain 43 présente lui aussi une surface étendue sur la face avant 44 de la deuxième puce 40, surface qui viendra en contact avec le premier plot de contact de source 32.

Avantageusement, le deuxième plot de contact de source 42, en face avant de la deuxième puce 40, est en contact avec le plot de contact additionnel supplémentaire 332 de la première puce 30.

Enfin, le plot de contact additionnel 331, le plot de contact additionnel supplémentaire 332, le premier plot de contact de drain 33 et le premier plot de contact de grille 31 sont respectivement connectés au terminal de grille 11, au terminal de source 12, au terminal de drain 13 et au terminal supplémentaire de grille 111.

Préférentiellement, au moins la connexion entre le plot de contact additionnel supplémentaire 332 et le terminal de source 12, et la connexion entre le premier plot de contact de drain 33 et le terminal de drain 13 sont réalisées au moyen de clips de raccordement électrique 20. Alternativement, la connexion entre le plot de contact additionnel supplémentaire 332 et le terminal de source 12 peut être fait au moyen d'un clip de raccordement électrique 20 entre la plaque structurelle 14 du boitier 10 et le plot de contact additionnel supplémentaire 332, le terminal de source 12 étant électriquement relié à la plaque structurelle 14.

La connexion entre le plot de contact additionnel 331 et le terminal de grille 11, et la connexion entre le premier plot de contact de grille 31 et le terminal supplémentaire de grille 111 sont réalisées au moyen de connexions filaires ou de clips de raccordement électrique 20.

Selon ce quatrième mode de réalisation de l'invention, on obtient un circuit intégré 100, dont les première 30 et deuxième 40 puces sont connectées en arrangement cascade : la grille du transistor à haute tension en mode déplétion de la première puce 30 (connectée au terminal supplémentaire de grille 111) peut être commandée indépendamment de la grille du dispositif en mode enrichissement de la deuxième puce 40 (connectée au terminal de grille 11).

Les résistances et inductances parasites liées aux connexions électriques entre les différents composants et éléments du circuit intégré 100 sont ici encore fortement réduites par rapport aux solutions de l'état de l'art, du fait des chemins de connexion fortement réduits et de l'utilisation préférentielle de clips de raccordement électrique au lieu de connexions filaires sur les chemins de courant du circuit intégré 100.

Dans le circuit intégré 100 selon les différents modes de réalisation de l'invention, le dispositif en mode enrichissement inclus dans la deuxième puce 40 pourra comprendre un transistor en mode enrichissement dont une électrode de grille est connectée au deuxième plot de contact de grille 41 de la deuxième puce 40. Le terminal de grille 11 du boitier 10, connecté au deuxième plot de contact de grille 41 permet alors de transmettre un signal électrique pour commander la grille du transistor en mode enrichissement (par exemple, un MOSFET sur silicium).

Alternativement, le dispositif en mode enrichissement inclus dans la deuxième puce 40 pourra comprendre un transistor en mode enrichissement et un composant de commande : dans ce cas, une électrode de grille du transistor en mode enrichissement est connectée à une entrée du composant de commande et une sortie du composant de commande est connectée au deuxième plot de contact de grille 41 de la deuxième puce 40. Le terminal de grille 11 du boitier 10, connecté au deuxième plot de contact de grille 41 permet ici d'envoyer un signal électrique au composant de commande ; ce dernier est ensuite apte à traiter ce signal pour commander la grille du transistor en mode enrichissement.

Bien entendu, l'invention n'est pas limitée aux modes de réalisation décrits et on peut y apporter des variantes de réalisation sans sortir du cadre de l'invention tel que défini par les revendications.

## Revendications

1. Circuit intégré (100) comprenant une première puce (30) comportant un transistor à haute tension en mode déplétion et une deuxième puce (40) comportant un dispositif en mode enrichissement, la première puce (30) comportant sur une face avant des premiers plots de contact de grille (31), de source (32) et de drain (33) et la deuxième puce (40) comportant des deuxièmes plots de contact de grille (41), de source (42) et de drain (43) ; le circuit intégré (100) étant **caractérisé en ce que** :
• La première puce (30) et la deuxième puce (40) sont assemblées entre elles au niveau de leurs faces avant (34,44) respectives et forment un empilement (50), la surface de la face avant (34) de la première puce (30) étant supérieure à celle de la deuxième puce (40) de manière à ce qu'une partie périphérique de la face avant (34) de la première puce (30) ne soit pas masquée par la deuxième puce (40),
• La première puce (30) comporte au moins un plot de contact additionnel (331) disposé sur sa face avant (34), isolé électriquement du transistor à haute tension en mode déplétion, et en contact avec le deuxième plot de contact de grille (41),
• Le premier plot de contact de grille (31) est en contact avec le deuxième plot de contact de source (42) et/ou le premier plot de contact de source (32) est en contact avec le deuxième plot de contact de drain (43),
• Le premier plot de contact de grille (31) et le plot de contact additionnel (331) s'étendent au moins en partie dans la partie périphérique de la première puce (30).

2. Circuit intégré (100) selon la revendication précédente, comprenant un boitier (10) comportant au moins trois terminaux électriques, un terminal de grille (11), un terminal de source (12) et un terminal de drain (13), et dans lequel est disposé l'empilement (50), la face arrière (35) de la première puce (30) étant disposée sur une plaque structurelle (14) du boitier (10) connectée au terminal de source (12).

3. Circuit intégré (100) selon la revendication précédente, dans lequel, le premier plot de contact de grille (31), en contact avec le deuxième plot de contact de source (42), s'étend au-dessus d'une région active du transistor de la première puce (30) et forme la surface principale d'assemblage entre la première puce (30) et la deuxième puce (40).

4. Circuit intégré (100) selon la revendication précédente, dans lequel le deuxième plot de contact de drain (43), en face arrière (45) de la deuxième puce (40), est connecté au premier plot de contact de source (32) situé dans la partie périphérique, au moyen d'un clip de raccordement électrique (20).

5. Circuit intégré (100) selon la revendication 2, dans lequel le premier plot de contact de source (32), en contact avec le deuxième plot de contact de drain (43), s'étend au-dessus d'une région active du transistor de la première puce (30) et forme la surface principale d'assemblage entre la première puce (30) et la deuxième puce (40).

6. Circuit intégré (100) selon la revendication précédente, dans lequel le deuxième plot de contact de source (42), en face arrière (45) de la deuxième puce (40), est connecté au premier plot de contact de grille (31) au moyen d'un clip de raccordement électrique (20).

7. Circuit intégré (100) selon la revendication 5, dans lequel le deuxième plot de contact de source (42), en face avant (44) de la deuxième puce (40), est en contact avec le premier plot de contact de grille (31).

8. Circuit intégré (100) selon l'une des revendications 4, 6 ou 7, dans lequel le plot de contact additionnel (331), le premier plot de contact de grille (31) et le premier plot de contact de drain (33) sont respectivement connectés au terminal de grille (11), au terminal de source (12) et au terminal de drain (13).

9. Circuit intégré (100) selon la revendication précédente, dans lequel au moins la connexion entre le premier plot de contact de grille (31) et le terminal de source (12), et la connexion entre le premier plot de contact de drain (33) et le terminal de drain (13) sont réalisées au moyen de clips de raccordement électrique (20).

10. Circuit intégré (100) selon la revendication précédente, dans lequel la connexion entre le premier plot de contact de grille (31) et le terminal de source (12) se fait au moyen d'un clip de raccordement électrique (20) entre la plaque structurelle (14) du boitier (10) et le premier plot de contact de grille (31), le terminal de source (12) étant électriquement relié à la plaque structurelle (14).

11. Circuit intégré (100) selon l'une des trois revendications précédentes, dans lequel la connexion entre le plot de contact additionnel (331) et le terminal de grille (11) est réalisée au moyen d'une connexion filaire ou d'un clip de raccordement électrique (20).

12. Circuit intégré (100) selon la revendication 1, comprenant un boitier (10) comportant au moins quatre terminaux électriques, un terminal de grille (11), un terminal de source (12), un terminal de drain (13) et un terminal supplémentaire de grille (111), et dans lequel est disposé l'empilement (50), la face arrière (35) de la première puce (30) étant disposée sur une plaque structurelle (14) du boitier (10) connectée au terminal de source (12).

13. Circuit intégré (100) selon la revendication précédente, dans lequel la première puce (30) comporte un plot de contact additionnel supplémentaire (332) disposé sur sa face avant (34), isolé électriquement du transistor à haute tension en mode déplétion, et s'étendant au moins en partie dans la partie périphérique de la première puce (30).

14. Circuit intégré (100) selon la revendication précédente, dans lequel, le premier plot de contact de source (32), en contact avec le deuxième plot de contact de drain (43), s'étend au-dessus d'une région active du transistor de la première puce (30) et forme la surface principale d'assemblage entre la première puce (30) et la deuxième puce (40).

15. Circuit intégré (100) selon l'une des deux revendications précédentes, dans lequel le deuxième plot de contact de source (42), en face avant (44) de la deuxième puce (40), est en contact avec le plot de contact additionnel supplémentaire (332).

16. Circuit intégré (100) selon la revendication précédente, dans lequel le plot de contact additionnel (331), le plot de contact additionnel supplémentaire (332), le premier plot de contact de drain (33) et le premier plot de contact de grille (31) sont respectivement connectés au terminal de grille (11), au terminal de source (12), au terminal de drain (13) et au terminal supplémentaire de grille (111).

17. Circuit intégré (100) selon la revendication précédente, dans lequel au moins la connexion entre le plot de contact additionnel supplémentaire (332) et le terminal de source (12), et la connexion entre le premier plot de contact de drain (33) et le terminal de drain (13) sont réalisées au moyen de clips de raccordement électrique (20).

18. Circuit intégré (100) selon la revendication précédente, dans lequel la connexion entre le plot de contact additionnel supplémentaire (332) et le terminal de source (12) se fait au moyen d'un clip de raccordement électrique (20) entre la plaque structurelle (14) du boitier (10) et le plot de contact additionnel supplémentaire (332), le terminal de source (12) étant électriquement relié à la plaque structurelle (14).

19. Circuit intégré (100) selon l'une des trois revendications précédentes, dans lequel la connexion entre le plot de contact additionnel (331) et le terminal de grille (11), et la connexion entre le premier plot de contact de grille (31) et le terminal supplémentaire de grille (111) sont réalisées au moyen de connexions filaires ou de clips de raccordement électrique (20).

20. Circuit intégré (100) selon l'une des revendications précédentes, dans lequel le dispositif en mode enrichissement inclus dans la deuxième puce (40) comprend un transistor en mode enrichissement dont une électrode de grille est connectée au plot de contact de grille (41) de la deuxième puce (40).

21. Circuit intégré (100) selon l'une des revendications 1 à 19, dans lequel le dispositif en mode enrichissement inclus dans la deuxième puce (40) comprend un transistor en mode enrichissement et un composant de commande, une électrode de grille du transistor en mode enrichissement étant connectée à une entrée du composant de commande et une sortie du composant de commande étant connectée au plot de contact de grille (41) de la deuxième puce (40).

## Patentansprüche

1. Integrierte Schaltung (100), umfassend einen ersten Chip (30) mit einem Hochspannungstransistor im Verarmungsmodus und einen zweiten Chip (40) mit einer Vorrichtung im Anreicherungsmodus, wobei der erste Chip (30) auf einer Vorderseite erste Kontaktflächen für Gate (31), Source (32) und Drain (33) und der zweite Chip (40) zweite Kontaktflächen für Gate (41), Source (42) und Drain (43) aufweist;
wobei die integrierte Schaltung (100) **dadurch gekennzeichnet ist, dass**:
• der erste Chip (30) und der zweite Chip (40) an ihren jeweiligen Vorderseiten (34, 44) miteinander verbunden sind und einen Stapel (50) bilden, wobei die Fläche der Vorderseite (34) des ersten Chips (30) größer ist als die des zweiten Chips (40), so dass ein peripherer Teil der Vorderseite (34) des ersten Chips (30) nicht durch den zweiten Chip (40) abgedeckt ist,
• der erste Chip (30) mindestens eine Zusatz-Kontaktfläche (331) aufweist, die auf seiner Vorderseite (34) angeordnet ist, im Verarmungsmodus von dem Hochspannungstransistor elektrisch isoliert ist und in Kontakt mit der zweiten Gate-Kontaktfläche (41) steht,
• die erste Gate-Kontaktfläche (31) in Kontakt mit der zweiten Source-Kontaktfläche (42) und/oder die erste Source-Kontaktfläche (32) in Kontakt mit der zweiten Drain-Kontaktfläche (43) steht,
• die erste Gate-Kontaktfläche (31) und die Zusatz-Kontaktfläche (331) sich zumindest teilweise in den peripheren Teil des ersten Chips (30) erstrecken.

2. Integrierte Schaltung (100) nach dem vorhergehenden Anspruch, umfassend ein Gehäuse (10) mit mindestens drei elektrischen Anschlüssen, einem Gate-Anschluss (11), einem Source-Anschluss (12) und einem Drain-Anschluss (13), und in dem der Stapel (50) angeordnet ist, wobei die Rückseite (35) des ersten Chips (30) auf einer Strukturplatte (14) des Gehäuses (10) angeordnet ist, die mit dem Source-Anschluss (12) verbunden ist.

3. Integrierte Schaltung (100) nach dem vorhergehenden Anspruch, wobei sich die erste Gate-Kontaktfläche (31), die mit der zweiten Source-Kontaktfläche (42) in Kontakt steht, über einen aktiven Bereich des Transistors des ersten Chips (30) erstreckt und die Hauptverbindungsfläche zwischen dem ersten Chip (30) und dem zweiten Chip (40) bildet.

4. Integrierte Schaltung (100) nach dem vorhergehenden Anspruch, wobei die zweite Drain-Kontaktfläche (43) auf der Rückseite (45) des zweiten Chips (40) mit der ersten Source-Kontaktfläche (32), die sich im peripheren Teil befindet, mittels einer elektrischen Verbindungsklemme (20) verbunden ist.

5. Integrierte Schaltung (100) nach Anspruch 2, wobei sich die erste Source-Kontaktfläche (32), die in Kontakt mit der zweiten Drain-Kontaktfläche (43) steht, über einen aktiven Transistorbereich des ersten Chips (30) erstreckt und die Hauptverbindungsfläche zwischen dem ersten Chip (30) und dem zweiten Chip (40) bildet.

6. Integrierte Schaltung (100) nach dem vorhergehenden Anspruch, wobei die zweite Source-Kontaktfläche (42) auf der Rückseite (45) des zweiten Chips (40) mit der ersten Gate-Kontaktfläche (31) mittels einer elektrischen Verbindungsklemme (20) verbunden ist.

7. Integrierte Schaltung (100) nach Anspruch 5, wobei die zweite Source-Kontaktfläche (42) auf der Vorderseite (44) des zweiten Chips (40) mit der ersten Gate-Kontaktfläche (31) in Kontakt steht.

8. Integrierte Schaltung (100) nach einem der Ansprüche 4, 6 oder 7, wobei die Zusatz-Kontaktfläche (331), die erste Gate-Kontaktfläche (31) und die erste Drain-Kontaktfläche (33) jeweils mit dem Gate-Anschluss (11), dem Source-Anschluss (12) und dem Drain-Anschluss (13) verbunden sind.

9. Integrierte Schaltung (100) nach dem vorhergehenden Anspruch, wobei zumindest die Verbindung zwischen der ersten Gate-Kontaktfläche (31) und dem Source-Anschluss (12) sowie die Verbindung zwischen der ersten Drain-Kontaktfläche (33) und dem Drain-Anschluss (13) mit Hilfe von elektrischen Verbindungsklemmen (20) hergestellt werden.

10. Integrierte Schaltung (100) nach dem vorhergehenden Anspruch, wobei die Verbindung zwischen der ersten Gate-Kontaktfläche (31) und dem Source-Anschluss (12) mittels einer elektrischen Verbindungsklemme (20) zwischen der Strukturplatte (14) des Gehäuses (10) und der ersten Gate-Kontaktfläche (31) hergestellt wird, wobei der Source-Anschluss (12) mit der Strukturplatte (14) elektrisch verbunden ist.

11. Integrierte Schaltung (100) nach einem der drei vorhergehenden Ansprüche, wobei die Verbindung zwischen der Zusatz-Kontaktfläche (331) und dem Gate-Anschluss (11) mittels einer Drahtverbindung oder einer elektrischen Verbindungsklemme (20) hergestellt wird.

12. Integrierte Schaltung (100) nach Anspruch 1, umfassend ein Gehäuse (10) mit mindestens vier elektrischen Anschlüssen, einem Gate-Anschluss (11), einem Source-Anschluss (12), einem Drain-Anschluss (13) und einem weiteren Gate-Anschluss (111), und in der der Stapel (50) angeordnet ist, wobei die Rückseite (35) des ersten Chips (30) auf einer Strukturplatte (14) des Gehäuses (10) angeordnet ist, die mit dem Source-Anschluss (12) verbunden ist.

13. Integrierte Schaltung (100) nach dem vorhergehenden Anspruch, wobei der erste Chip (30) eine weitere Zusatz-Kontaktfläche (332) aufweist, die auf seiner Vorderseite (34) angeordnet ist, elektrisch isoliert von dem Hochspannungstransistor im Verarmungsmodus ist und sich zumindest teilweise in den peripheren Teil des ersten Chips (30) erstreckt.

14. Integrierte Schaltung (100) nach dem vorhergehenden Anspruch, wobei sich die erste Source-Kontaktfläche (32), die in Kontakt mit der zweiten Drain-Kontaktfläche (43) steht, über einen aktiven Transistorbereich des ersten Chips (30) erstreckt und die Hauptverbindungsfläche zwischen dem ersten Chip (30) und dem zweiten Chip (40) bildet.

15. Integrierte Schaltung (100) nach einem der beiden vorhergehenden Ansprüche, wobei die zweite Source-Kontaktfläche (42) auf der Vorderseite (44) des zweiten Chips (40) mit der weiteren Zusatz-Kontaktfläche (332) in Kontakt steht.

16. Integrierte Schaltung (100) nach dem vorhergehenden Anspruch, wobei die Zusatz-Kontaktfläche (331), die weitere Zusatz-Kontaktfläche (332), die erste Drain-Kontaktfläche (33) und die erste Gate-Kontaktfläche (31) jeweils mit dem Gate-Anschluss (11), dem Source-Anschluss (12), dem Drain-Anschluss (13) und dem weiteren Gate-Anschluss (111) verbunden sind.

17. Integrierte Schaltung (100) nach dem vorhergehenden Anspruch, wobei zumindest die Verbindung zwischen der weiteren Zusatz-Kontaktfläche (332) und dem Source-Anschluss (12) und die Verbindung zwischen der ersten Drain-Kontaktfläche (33) und dem Drain-Anschluss (13) mit Hilfe von elektrischen Verbindungsklemmen (20) hergestellt werden.

18. Integrierte Schaltung (100) nach dem vorhergehenden Anspruch, wobei die Verbindung zwischen der weiteren Zusatz-Kontaktfläche (332) und dem Source-Anschluss (12) mittels einer elektrischen Verbindungsklemme (20) zwischen der Strukturplatte (14) des Gehäuses (10) und der weiteren Zusatz-Kontaktfläche (332) hergestellt wird, wobei der Source-Anschluss (12) mit der Strukturplatte (14) elektrisch verbunden ist.

19. Integrierte Schaltung (100) nach einem der drei vorhergehenden Ansprüche, wobei die Verbindung zwischen der zusätzlichen Gate-Kontaktfläche (331) und dem Gate-Anschluss (11) sowie die Verbindung zwischen der ersten Gate-Kontaktfläche (31) und dem weiteren Gate-Anschluss (111) mittels Drahtverbindungen oder elektrischen Verbindungsklemmen (20) hergestellt werden.

20. Integrierte Schaltung (100) nach einem der vorhergehenden Ansprüche, wobei das im zweiten Chip (40) enthaltene Gerät im Anreicherungsmodus einen Transistor im Anreicherungsmodus umfasst, von dem eine Gate-Elektrode mit der Gate-Kontaktfläche (41) des zweiten Chips (40) verbunden ist.

21. Integrierte Schaltung (100) nach einem der Ansprüche 1 bis 19, wobei das im zweiten Chip (40) enthaltene Gerät im Anreicherungsmodus einen Transistor im Anreicherungsmodus und eine Steuerkomponente umfasst, wobei eine Gate-Elektrode des Transistors im Anreicherungsmodus mit einem Eingang der Steuerkomponente verbunden ist und wobei ein Ausgang der Steuerkomponente mit der Gate-Kontaktfläche (41) des zweiten Chips (40) verbunden ist.

## Claims

1. Integrated circuit (100), comprising a first chip (30) having a high-voltage transistor in depletion mode and a second chip (40) having a device in enhancement mode, the first chip (30) having, on a front face, first gate (31), source (32) and drain (33) contact pads, and the second chip (40) having second gate (41), source (42) and drain (43) contact pads; the integrated circuit (100) being **characterized in that**:
• the first chip (30) and the second chip (40) are mutually joined at the respective front faces (34, 44) thereof and form a stack (50), the surface area of the front face (34) of the first chip (30) being greater than that of the second chip (40) such that a peripheral portion of the front face (34) of the first chip (30) is not masked by the second chip (40),
• the first chip (30) has at least one additional contact pad (331) arranged on the front face (34) thereof, which contact is electrically isolated from the high-voltage transistor in depletion mode and is in contact with the second gate contact pad (41),
• the first gate contact pad (31) is in contact with the second source contact pad (42) and/or the first source contact pad (32) is in contact with the second drain contact pad (43),
• the first gate contact pad (31) and the additional contact pad (331) extend in the peripheral portion of the first chip (30), at least in part.

2. Integrated circuit (100) according to the preceding claim, comprising a housing (10) having at least three electrical terminals, namely a gate terminal (11), a source terminal (12) and a drain terminal (13), and in which circuit the stack (50) is arranged, the rear face (35) of the first chip (30) being arranged on a structural plate (14) of the housing (10), which plate is connected to the source terminal (12).

3. Integrated circuit (100) according to the preceding claim, wherein the first gate contact pad (31), in contact with the second source contact pad (42), extends over an active region of the transistor of the first chip (30) and forms the main joining surface between the first chip (30) and the second chip (40).

4. Integrated circuit (100) according to the preceding claim, wherein the second drain contact pad (43), on the rear face (45) of the second chip (40), is connected to the first source contact pad (32), located in the peripheral portion, by means of an electrical connector clip (20).

5. Integrated circuit (100) according to claim 2, wherein the first source contact pad (32), in contact with the second drain contact pad (43), extends over an active region of the transistor of the first chip (30) and forms the main joining surface between the first chip (30) and the second chip (40).

6. Integrated circuit (100) according to the preceding claim, wherein the second source contact pad (42), on the rear face (45) of the second chip (40), is connected to the first gate contact pad (31) by means of an electrical connector clip (20).

7. Integrated circuit (100) according to claim 5, wherein the second source contact pad (42), on the front face (44) of the second chip (40), is in contact with the first gate contact pad (31).

8. Integrated circuit (100) according to any of claims 4, 6 or 7, wherein the additional contact pad (331), the first gate contact pad (31) and the first drain contact pad (33) are connected to the gate terminal (11), the source terminal (12) and the drain terminal (13), respectively.

9. Integrated circuit (100) according to the preceding claim, wherein at least the connection between the first gate contact pad (31) and the source terminal (12) and the connection between the first drain contact pad (33) and the drain terminal (13) are achieved by means of electrical connector clips (20).

10. Integrated circuit (100) according to the preceding claim, wherein the connection between the first gate contact pad (31) and the source terminal (12) is made by means of an electrical connector clip (20) between the structural plate (14) of the housing (10) and the first gate contact pad (31), the source terminal (12) being electrically coupled to the structural plate (14).

11. Integrated circuit (100) according to any of the three preceding claims, wherein the connection between the additional contact pad (331) and the gate terminal (11) is achieved by means of a wire connection or an electrical connector clip (20).

12. Integrated circuit (100) according to claim 1, comprising a housing (10) having at least four electrical terminals, namely a gate terminal (11), a source terminal (12), a drain terminal (13) and an auxiliary gate terminal (111), and in which circuit the stack (50) is arranged, the rear face (35) of the first chip (30) being arranged on a structural plate (14) of the housing (10), which plate is connected to the source terminal (12).

13. Integrated circuit (100) according to the preceding claim, wherein the first chip (30) has an additional auxiliary contact pad (332) arranged on the front face (34) thereof, which contact is electrically isolated from the high-voltage transistor in depletion mode and extends in the peripheral portion of the first chip (30), at least in part.

14. Integrated circuit (100) according to the preceding claim, wherein the first source contact pad (32), in contact with the second drain contact pad (43), extends over an active region of the transistor of the first chip (30) and forms the main joining surface between the first chip (30) and the second chip (40).

15. Integrated circuit (100) according to either of the two preceding claims, wherein the second source contact pad (42), on the front face (44) of the second chip (40), is in contact with the additional auxiliary contact pad (332).

16. Integrated circuit (100) according to the preceding claim, wherein the additional contact pad (331), the additional auxiliary contact pad (332), the first drain contact pad (33) and the first gate contact pad (31) are connected to the gate terminal (11), the source terminal (12), the drain terminal (13) and the auxiliary gate terminal (111), respectively.

17. Integrated circuit (100) according to the preceding claim, wherein at least the connection between the additional auxiliary contact pad (332) and the source terminal (12) and the connection between the first drain contact pad (33) and the drain terminal (13) are achieved by means of electrical connector clips (20).

18. Integrated circuit (100) according to the preceding claim, wherein the connection between the additional auxiliary contact pad (332) and the source terminal (12) is made by means of an electrical connector clip (20) between the structural plate (14) of the housing (10) and the additional auxiliary contact pad (332), the source terminal (12) being electrically coupled to the structural plate (14).

19. Integrated circuit (100) according to any of the three preceding claims, wherein the connection between the additional contact pad (331) and the gate terminal (11) and the connection between the first gate contact pad (31) and the auxiliary gate terminal (111) are achieved by means of wire connections or electrical connector clips (20).

20. Integrated circuit (100) according to any of the preceding claims, wherein the device in enhancement mode included in the second chip (40) comprises a transistor in enhancement mode, a gate electrode of which is connected to the gate contact pad (41) of the second chip (40).

21. Integrated circuit (100) according to any of claims 1 to 19, wherein the device in enhancement mode included in the second chip (40) comprises a transistor in enhancement mode and a control component, a gate electrode of the transistor in enhancement mode being connected to an input of the control component and an output of the control component being connected to the gate contact pad (41) of the second chip (40).
